# EUROPEAN PATENT APPLICATION

(11) **EP 4 322 715 A1**
(43) Date of publication of application: **14.02.2024**
(21) Application number: 23190291.7
(22) Date of filing: 08.08.2023
(51) Int. Cl.: H05K 3/00, H01L 23/15, H05K 1/03

(54) **CORE-SUBSTRATE, SUBSTRATE AND USE OF SUBSTRATE FOR SEMICONDUCTOR PACKAGING**

(30) Priority: 10.08.2022 US 202263396615 P
(71) Applicant: Absolics Inc., Covington, GA 30014 (US)
(72) Inventor: KIM, Tae Kyoung, Covington, 30014 (US)
(74) Representative: BCKIP Part mbB

(57) **Abstract**

The present disclosure relates to a core-substrate (100), a substrate, a use of the substrate, and a semiconductor device comprising the same, wherein the core-substrate (100) is a core-substrate applied to the manufacture of a semiconductor packaging substrate, and the core-substrate (100) distinguished into a product area (10) where a product utilized as a substrate of an individual semiconductor is disposed; and a blank area excepting for the product area, wherein the blank area comprises a protective area (25) disposed between the product area (10) and the substrate, and the protective area (25) comprises a concave (251, 255) or a via. The embodiment can substantially suppress the occurrence of damage in the product area utilized as a substrate for semiconductor packaging, even though a core-substrate which may be easily broken by external impact.

## Description

### CROSS-REFERENCE TO RELATED APPLICATION

This application claims the priority of U.S. Provisional Patent Application No. 63/396,615, filed August 10, 2022.

### BACKGROUND

### Field

The present disclosure relates to a core-substrate improved in the processability and yield of manufacture with excellent effects such as preventing breakage, use of a substrate for substrate semiconductor packaging, and the like.

### Description of Related Art

In the manufacturing of electronic components, the implementation of a circuit on a semiconductor wafer is referred to as a Front-End Process (FE), and the assembly of a wafer such that it can be actually used in a product is referred to as a Back-End Process (BE). Back-End process includes a packaging process.

Four key technologies of the semiconductor industry that enable the rapid development of electronic products in recent years include semiconductor technology, semiconductor packaging technology, manufacturing process technology, and software technology. Semiconductor technology has been developed in various forms such as line width of a nanometer unit, which is smaller than a micrometer unit, 10 million or more cells, high-speed operation, and much heat emission, but is not supported by packaging technology completely. Thus, it is considered that the electrical performance of packaged semiconductors may be determined by the packaging technology with electrical connection rather than the performance of the semiconductor itself.

Ceramic or resin is used as the material of a packaging substrate. In the case of a ceramic substrate, it is not easy to mount a high-performance and high frequency semiconductor element thereon due to a high resistance or high dielectric constant. In the case of a resin substrate, it is relatively easy to mount a high-performance and high frequency semiconductor element thereon, but there is a distinct limitation to the reduction of pitches of conductive lines.

Recently, researches are being conducted to apply silicon or glass to a high-end packaging substrate. By forming a through-via on a silicon or glass substrate and applying a conductive material into the through-via, it is possible to shorten the length of a conductive line between an element and a motherboard, and have excellent electric characteristics.

As prior art in the related art, there is Korean Patent No. 10-2004-0017552. But this disclosure differs in that it relates to a substrate for display, not a substrate for packaging.

### SUMMARY

The present disclosure has objectives in providing a core-substrate and a substrate for semiconductor packaging that can prevent the substrate from being broken during the manufacturing process, improve processability and manufacturing yield and, and the use thereof.

In one general aspect, a core-substrate according to one embodiment is a core-substrate for a manufacture of a semiconductor packaging substrate, wherein the core-substrate is distinguished into a product area and a blank area, where the product area is an area that a product utilized as a substrate of an individual semiconductor is disposed; and the blank area is an area excepting for the product area, wherein a protective area is disposed at the blank area, and the protective area comprises a concave or a via.

The protective area may include a concave or a via.

The core-substrate may be a ceramic substrate or a glass substrate.

The core-substrate may be a substrate selected from the group consisting of a silicon-based ceramic substrate, a glass-based ceramic substrate, a glass substrate, and combinations thereof.

The product area may be an area where one, two, or more individual packaging substrates are disposed.

The via or the concave may be arranged in a row surrounding at least some of the edge of the product area.

The via or the concave may have the shape of an oval or a quadrangle having a length of 20 % to 150 % of one side of the edge of the product area.

The inside of the via or the concave is disposed an electrically conductive material, an insulating material, or both of them.

The protective area may include two or more rows respectively having different distances from the edge of the product area.

The two or more rows may include a first row and a second row arranged side by side.

A via of the first row and a via of the second row may be staggered with each other.

The protective area protects the product area from damage, which goes into the internal of the core-substrate from the edge of the core-substrate.

A substrate according to another embodiment is a substrate applied to the manufacture of a semiconductor packaging substrate, includes the core-substrate described in the above, and the core-substrate includes one side and the other side facing each other.

An upper rewiring layer may be disposed on one side of the core-substrate.

A lower rewiring layer may be disposed under the other side of the core-substrate.

The upper rewiring layer may include an upper insulating layer and an upper electronically conductive layer disposed in the upper insulating layer.

The lower rewiring layer may include a lower insulating layer and a lower electronically conductive layer disposed in the lower insulating layer.

A bump may be disposed in the upper rewiring layer, the lower rewiring layer, or both rewiring layers.

The lower rewiring layer or the bump may have a coefficient of thermal expansion larger than the coefficient of the core-substrate.

The concave or the via may function as a stopper when damage occurs in the core-substrate.

The via or the concave has a shape of some removed parts of the core-substrate.

The removed parts may be a space which is not filled with other materials.

The removed parts may be filled with a filling material.

The filling material may include a heat radiating material, an insulating material, or both of them.

A substrate according to another embodiment is a substrate utilized in semiconductor packaging, and the substrate includes a core-substrate. The core-substrate is distinguished into a product area where a product utilized as a substrate of an individual semiconductor is disposed; and a blank area excepting for the product area, wherein the blank area includes a protective area disposed to surround the product area, and the protective area substantially suppresses damage, which occurs in the direction substantially perpendicular to the thickness direction from the edge of the core-substrate, not to go into the product area.

A use of the substrate according to another embodiment is the use of a substrate including a glass plate for manufacturing a substrate for semiconductor packaging, and the core-substrate is distinguished into a product area where a product utilized as a packaging substrate of an individual semiconductor is disposed; and a blank area excepting for the product area, wherein the blank area includes a protective area disposed to surround the product area, the substrate has a use of mounting semiconductor elements, and the semiconductor elements are mounted on one side of the substrate and/or in a cavity space of the substrate.

A semiconductor device according to another embodiment includes a substrate described in the above and an element placed in the substrate.

### BRIEF DESCRIPTION OF THE DRAWINGS

FIG.1 is a conceptual view for illustrating one or more exemplary configuration of a core-substrate.
FIG.2 is a conceptual view for illustrating one or more exemplary configuration of a core-substrate.
FIG.3 is a conceptual view for illustrating one or more exemplary configuration of a core-substrate of an embodiment.
FIG.4A is a schematic drawing for illustrating the view of a substrate according to one or more embodiment seen in an upper position.
FIG.4B is a schematic drawing for illustrating the view of a substrate according to one or more embodiment seen in an upper position.
FIG.5A is a schematic drawing for illustrating the view of a core-substrate according to one or more embodiment seen in an upper position.
FIG.5B is a schematic drawing for illustrating one example of the section of a core-substrate seen in A-A' line of FIG.5.
FIG.5C is a schematic drawing for illustrating the view of a core-substrate according to one or more embodiment seen in an upper position.
FIG.6A is a schematic drawing for illustrating the view of a core-substrate according to one or more embodiment seen in an upper position.
FIG.6B is a schematic drawing for illustrating another example of the section of a core-substrate seen in A-A' line of FIG.6A.
FIG.7 and FIG.8 are respectively conceptual views for illustrating a protective area according to one or more embodiments.
FIG.9 and FIG. 10 are respectively conceptual views for illustrating a structure of a substrate according to one or more embodiments by using a section.
FIG. 11A and FIG.11B are conceptual views for illustrating the view of damage occurring in a core-substrate during a manufacturing process of a substrate applied to the manufacture of a semiconductor packaging substrate.

### DESCRIPTION OF THE EMBODIMENTS

Hereinafter, example embodiments of the present disclosure will be described in detail with reference to the accompanying drawings so that they can be easily practiced by those skilled in the art to which the present invention pertains. However, the example embodiments may be embodied in many different forms and is not to be construed as being limited to the embodiments set forth herein. Like reference numerals designate like elements throughout the specification.

Throughout this application, the phrase "combination(s) thereof' included in a Markush-type expression denotes one or more mixtures or combinations selected from the group consisting of components stated in the Markush-type expression, that is, denotes one or more components selected from the group consisting of the components are included.

Throughout this application, terms such as "first", "second", "A", or "B" are used to distinguish the same terms from each other unless specially stated otherwise.

In this application, "~" based may refer to including a compound corresponding to "~" or derivative of "~" in a compound.

In this application, "B being placed on A" means that B is placed in direct contact with A or placed over A with another layer or structure interposed therebetween and thus should not be interpreted as being limited to B being placed in direct contact with A.

In this application, "B being connected to A" means that B is connected to A directly or through another element therebetween, and thus should not be interpreted as being limited to B being directly connected to A, unless otherwise noted.

In this application, a singular form is contextually interpreted as including a plural form as well as a singular form unless specially stated otherwise.

In this application, the high frequency refers to a frequency of about 1 GHz to about 300 GHz. Specifically, the high frequency may refer to a frequency of about 1 GHz to about 30 GHz, or a frequency of about 1 GHz to about 15 GHz.

In this application, the fine line refers to a line having a width of 5 µm or less, and for example, refers to a line having a width of 1 to 4 µm.

In this application, the shape, the relative size, the angle, etc., of each component in drawings are examples and may be expressed to be exaggerated for description, and the right cannot be analyzed by limitation to the drawings.

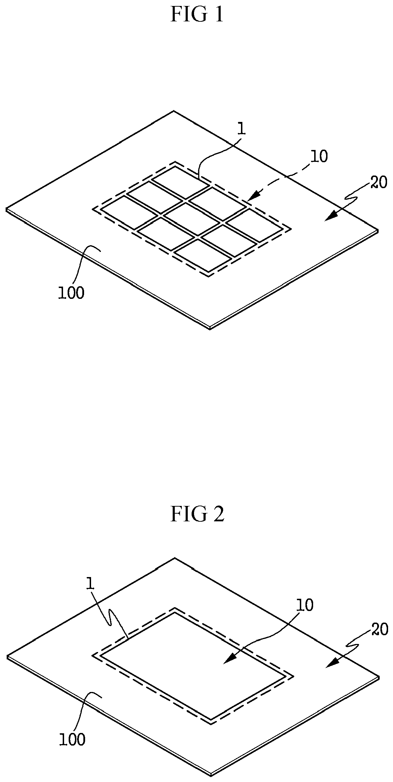

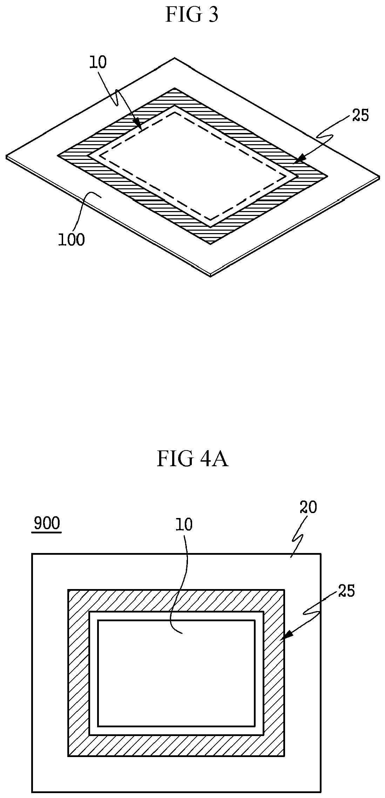

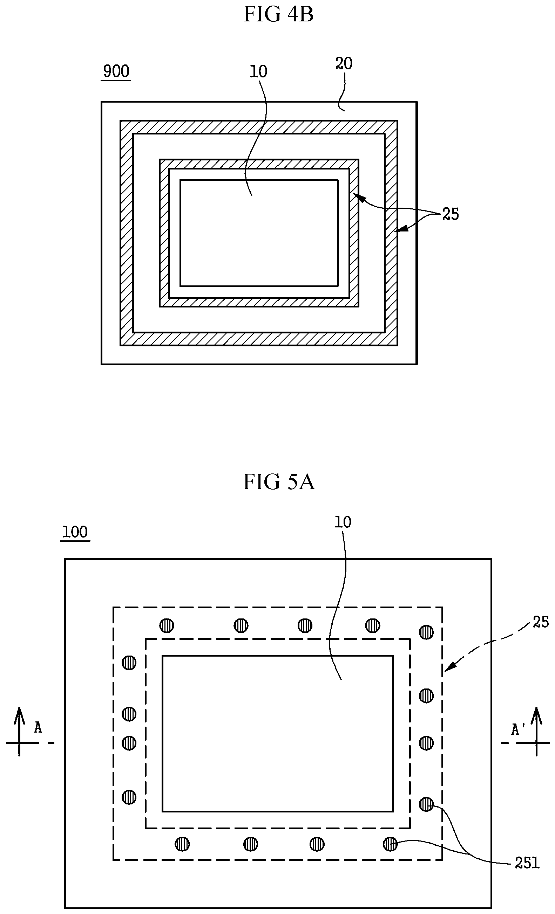

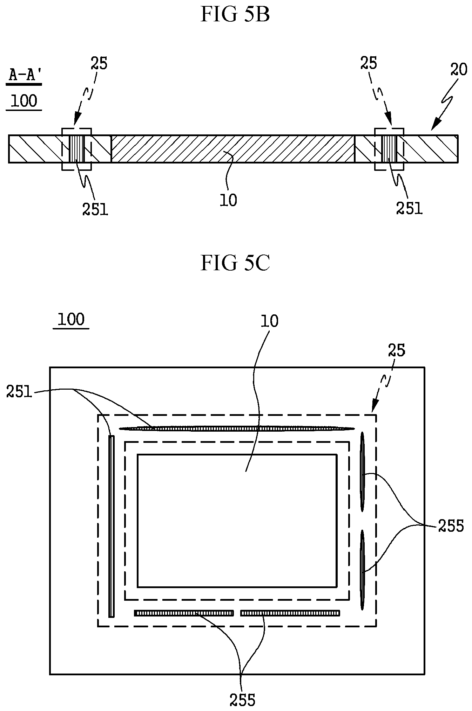

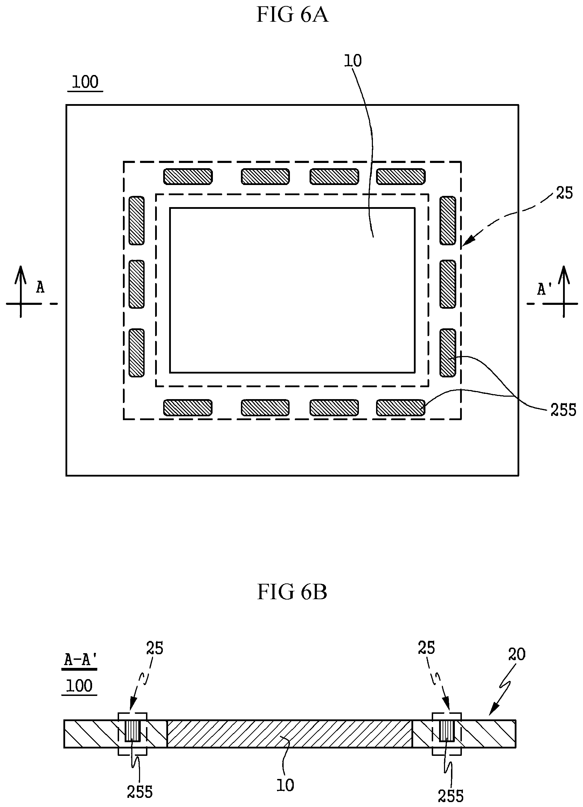

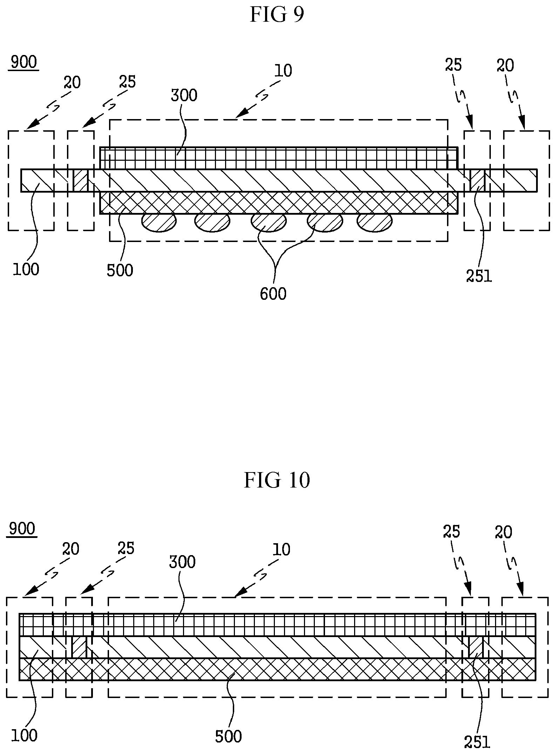

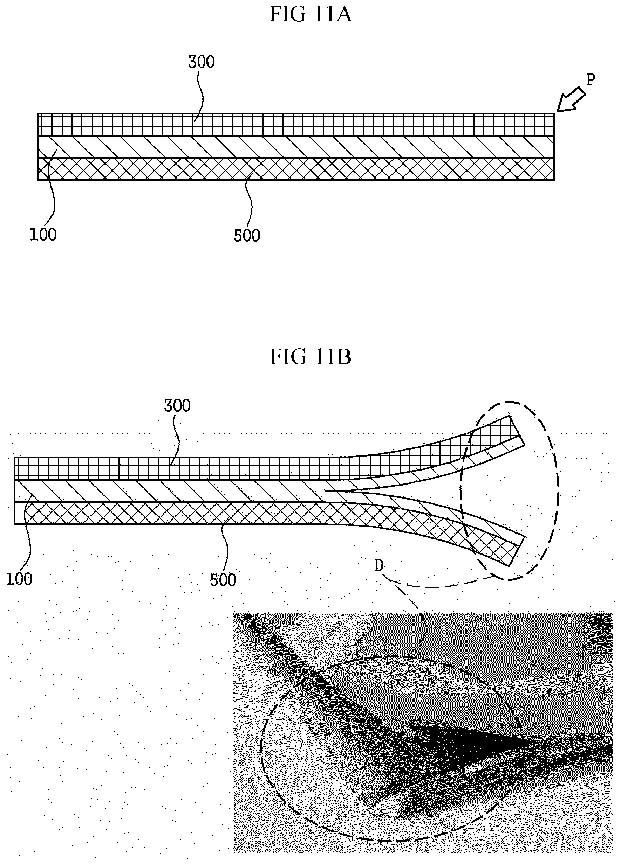

FIG. 1 is a conceptual view for illustrating an exemplary configuration of a core-substrate, FIG.2 is a conceptual view for illustrating another exemplary configuration of a core-substrate, FIG.3 is a conceptual view for illustrating exemplary configuration of a core-substrate of an embodiment, FIG.4A is a schematic drawing for illustrating the view of a substrate according to an embodiment seen in an upper position, FIG.4B is a schematic drawing for illustrating the view of a substrate according to another embodiment seen in an upper position, FIG.5A is a schematic drawing for illustrating the view of a core-substrate according to an embodiment seen in an upper position, FIG.5B is a schematic drawing for illustrating one example of the section of a core-substrate seen in A-A' line of FIG.5, FIG.5C is a schematic drawing for illustrating the view of a core-substrate according to another embodiment seen in an upper position, FIG.6A is a schematic drawing for illustrating the view of a core-substrate according to another embodiment seen in an upper position, FIG.6B is a schematic drawing for illustrating another example of the section of a core-substrate seen in A-A' line of FIG.6A, FIG.7 and FIG.8 are respectively conceptual views for illustrating a protective area according to embodiments, FIG.9 and FIG. 10 are respectively conceptual views for illustrating a structure of a substrate according to embodiments by using a section. Also, FIG.11A and FIG.11B are conceptual views for illustrating the view of damage occurring in a core-substrate during a manufacturing process of a substrate applied to the manufacture of a semiconductor packaging substrate. Hereinafter, example embodiments will be described in detail with reference to the drawings.

A manufacturing process of a semiconductor packaging substrate comprises a process of forming build-up layers in plural steps on a core-substrate as an essential operation. The build-up layers are formed through dozens or hundreds of repetitive heating and cooling processes. A core-substrate serves as a supporter in these processes, and gets stress from heat and pressure continuedly.

The inventors observed that when a core-substrate was impacted during a process for forming build-up layers or after the formation of build-up layers, particular damage occurred in the substrate. When a ceramic substrate or a glass substrate is damaged by reacting to external impact (P), some of the edge may fall or the substrate may be broken into two or more fragments, in many cases. The damage observed by the inventors is damage (D) in the direction perpendicular to the thickness of the substrate, and thus has singularity (Refer to FIG. 11A and FIG.11B). The inventors judged such a phenomenon was caused due to stress accumulated in a core-substrate during a manufacturing process of build-up layers, which may influence to the substrate, and thereby the substrate was damaged by weak impact which could not break the core-substrate by oneself in usual environments. Accordingly, a substrate which can suppress substantially the occurrence of damage in a product area, even though damage occurs in some of a core-substrate during a manufacturing process of a substrate for semiconductor packaging, is disclosed in embodiments.

### Core-substrate 100

In one general aspect, a core-substrate 100 according to one embodiment is applied to the manufacture of a semiconductor packaging substrate.

A core-substrate 100 of one or more embodiment serves as a supporter in a packaging substrate. Accordingly, the core-substrate is distinguished from a rewiring layer, dielectric layer or insulating layer disposed on or under the core-substrate.

As a core-substrate 100 of one or more embodiment, a ceramic substrate, a glass substrate, or a substrate made from a combination thereof may be applied.

A ceramic substrate may be for example, a silicon-based ceramic substrate, a glass-based ceramic substrate, and the like. The silicon-based substrate may be a substrate comprising a silicon substrate, a silicon carbide substrate, and the like in some or the whole thereof. The glass-based ceramic substrate may be a substrate comprising a quartz substrate, a sapphire substrate, and the like in some or the whole thereof.

A glass substrate may be applied if it is glass plate applied in an electronic component.

A glass substrate may be for example, an alkali borosilicate glass plate, a non-alkali borosilicate glass plate, a non-alkali alkali-earth borosilicate glass plate, and the like, and any glass plate applicable as an electronic component may be applied thereto.

A core-substrate 100 may have a thickness of 50 µm or more, 100 µm or more, 150 µm or more, 200 µm or more, 250 µm or more, 300 µm or more, or 350 µm or more. The core-substrate may have a thickness of 3000 µm or less, 1000 µm or less, 700 µm or less or 500 µm or less. When the core-substrate is applied in such a thickness range, great utilization as a substrate for semiconductor packaging can be obtained.

The core-substrate 100 is distinguished into a product area 10 where a product(s) utilized as an individual semiconductor packaging substrate is disposed; and a blank area 20 excepting for the product area.

A substrate applied to the manufacture of a substrate for semiconductor packaging has a blank, which is ordinarily called as a margin area. An area to be a product which is disposed in the center of a substrate in ordinary cases is separated from the substrate into the product through the singulation process, and the line separated from the substrate in the singulation process is called the product boundary line (s) 1.

One product boundary line may be arranged per one substrate, and in such a case, one product of a substrate for semiconductor packaging may be manufactured from one substrate. The product boundary line may be in plural numbers of two or more per one substrate, and in such a case, plural products of a substrate for semiconductor packaging may be manufactured from one substrate. That is, the product area may allow one, two, or more products to be arranged. In the borderline of the product area, one borderline of the product utilized as an individual semiconductor substrate may be disposed (Refer to FIG.2). Also, two or more borderlines may be arranged (Refer to FIG. 1.).

The areas out of the product area borderline are maintained during a manufacturing process for a substrate for semiconductor packaging, and removed in the operation of completing a product, in ordinary cases. In an embodiment, the areas to be a product -for example, the inner area of a line linking the outermost outlines of product boundary lines- are referred to as a product area 10. Also, non-product areas to be removed in the operation of product completion -for example, the area from a line liking the outermost outlines of the product boundary lines to the edge of a substrate- are referred to as a blank area 20 (Refer to FIG. 1 and FIG.2).

An embodiment introduces a protective area 25 on the substrate along with the product area 10 and the margin area 20 for preventing damage of a product.

The protective area 25 can protect the product area from damage going into the internal of the core-substrate from the edge of the core-substrate.

The protective area 25 may be disposed between the product area 10 and the edge of the substrate. The protective area 25 is disposed in a blank area 20 (Refer to FIG.3).

The protective area 25 may be disposed between one edge of the product area and the edge of the substrate. The protective area 25 may be arranged to surround the product area.

One protective area 25 may be disposed in one core-substrate (refer to FIG.4A), and two or more protective areas may be disposed to be separate (Refer to FIG.4B).

The protection area 25 may protect the product area from damage spreading from the edge of the core-substrate to the inside of the core-substrate.

The protective area 25 of one or more embodiment may comprise a via 251 (Refer to FIG.5A and FIG.5B).

In an embodiment, the via 251 refers to a through hole in the shape of penetrating a core-substrate in the thickness direction. The shape of an entrance of the via -the plane where the surface of a core-substrate and a via meet- is not limited to a circle shape. For example, the shape of the entrance may be applied by various shapes such as a circle, an oval, a quadrangle, a rectangular, a square, a lozenge, and a triangle, and the shape of an entrance is not analyzed as being limited to a circle shape, even though the entrance is referred to as a via.

The protective area 25 of one or more embodiment may comprise a concave 255 (Refer to FIG.6A and FIG.6B).

In an embodiment, a concave 255 refers to a slot of a core-substrate concaved in the thickness direction. The shape of an entrance of the concave -the plane where the surface of a core-substrate and a concave meet- is not limited to a circle shape. For example, the shape of the entrance may be applied by various shapes such as a circle, an oval, a quadrangle, a rectangular, a square, a lozenge, and a triangle, and the shape of an entrance is not analyzed as being limited to a circle shape, even though the entrance is referred to as a concave. The concave may have a depth of 99 % or less, 90 % or less, 70 % or less, or 60 % or less of the thickness thereof. And concave may have a depth of 30 % or, or 40 % or more of the thickness thereof.

In one or more embodiment, the entrance of a concave 255 may be disposed on one side of a core-substrate, may be disposed on the other side of the core-substrate. And a plural concave 255 may be disposed in one side and the other side of the core-substrate, respectively.

A shape of the cross section of the via or the concave may be applied to any shapes such as a circle, an oval, a quadrangle or combination thereof. Also, a long oval type or a long quadrangle type via (or concave) as an opening may be applied (Refer to FIG.5C). At this time, the long oval or the long quadrangle may be one having a ratio of 5 or more for the length to the width of an entrance, when a via or a concave are viewed in an upper position. Specifically, the ratio may be less than or equal to 200.

The via 251 or the concave 255 may be disposed in one side of the edge of the product area, and may be manufactured to be a long shape. Conventionally, forming a via or a concave through chemical etching on a substrate made from a material like prepreg is substantially difficult. In the embodiment, a via or a concave at the substrate can be formed through a process comprising chemical etching, and it is possible to set the shape of a via or a concave, or the area to be removed, more freely. That is, there is an advantage of enabling the formation of a concave or a via in a long shape or a wide area.

The diameter (or length) of the via or the concave is not specially limited. For example, the size of the via or the concave may be 30 µm or more, 50 µm or more, or 100 µm or more. For example, the size may be 20 mm or less, or 10 mm or less.

The via 251 or the concave 255 may have the shape of an oval or a quadrangle having a length of 20 % to 150 % of one side of the edge of the product area. The length of the via or the concave may be a value of 30 to 120 %, or 40 % to 100 % of one side of the edge of the product area. When a via or a concave in such a long shape is formed, a product area can be further efficiently protected as being irrelevant to the position where damage occurs depending on impact.

The via 251 or the concave 255 may be arranged in a row surrounding at least some of the edge of the product area. However, the row means plural vias formed to be arranged having regular or non-regular intervals. The via or the concave comprised in a row is not limited to a case necessarily having regular intervals in a row. For example, a via or a concave is formed having substantially regular intervals from the product area, and the group of such a via or concave can be considered as the protective area.

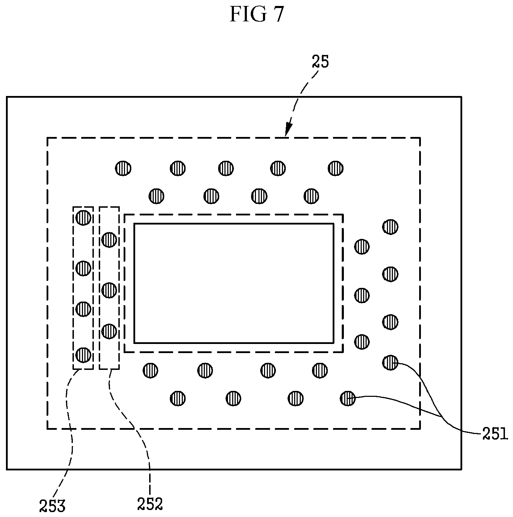

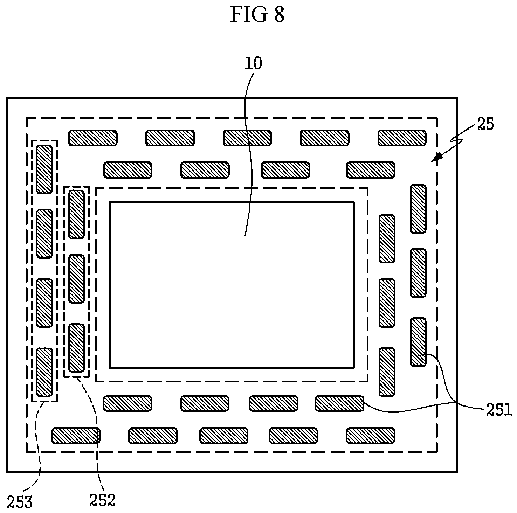

The protective area 25 may comprise two or more rows disposed to have different distances from the edge of the product area 10 (Refer to FIG.7 and FIG.8).

The two or more rows may comprise a first row 252 and a second row 253 arranged side by side. A via of the first row and a via of the second row may be staggered with each other.

The via 251 or the concave 255 according to one or more embodiments, may be hollow inside. The via or the concave is not disposed in the product area, and they may be empty in which an insulating layer or an electrically conductive layer (for example, a metal such as copper) is not embedded.

The via 251 or the concave 255 according to one or more embodiments, may be filled with a different material than the material of the core substrate. A metal layer may be plated in the via or concave. An electrically conductive layer may be disposed in the via or concave. Materials such as copper or a copper alloy can be used for the electrically conductive layer, but are not limited thereto. An insulating layer may be disposed in the via or concave. The insulating layer can be a mixture of inorganic particles and a polymer resin, but is not limited thereto. A metal and an insulating layer may be mixed in the via or concave. When the inside of the via or concave is filled with a different material than the material of the core substrate, it is considered that the effect of preventing breakage of the protected area is better.

The via 251 or the concave 255 may serve as a stopper for suppressing damage, which may occur in a substrate in the direction substantially perpendicular to the thickness of a core-substrate, not to go into a product area. Through the above, the yield of product manufacture can also be improved.

A substrate applied to the manufacture of a semiconductor packaging substrate may have a concave or a via, which is formed in a blank area to serve as a marker on the product or to function as distinguishing the upper and lower. In such a case, ordinarily a concave or a via is formed in the edge of a substrate, or an alphabet may be etched in the edge of a substrate.

On the other hand, in a core-substrate of the embodiment, a via or a concave is formed repetitively between the edge of the core-substrate and the product area, and this can be distinguished from a marker for identification, which may distinguish the type of a substrate or the upper and lower in the substrate. However, a via or a concave formed asymmetrically or in a specific shape can serve as a marker in addition to forming a protective area of the embodiment.

A manufacturing method of a core-substrate will be described.

The core-substrate is manufactured to form a protective area by etching a plate-shaped ceramic substrate or a plate-shaped glass substrate (referred to as a substrate material for convenience). The ceramic substrate may be applied by an ordinary silicon substrate or a silicon carbide substrate, and the thickness may be adjustable. The glass substrate may be applied by a glass substrate for electronic devices, and for example one manufactured by SHOTT, AGC, Corning Incorporated, or the like, but the substrate is not limited thereto.

A concave or a via formed in the protective area may be manufactured to be substantially similar to the manufacture of a through hole (Though Silicon Via, TSV; Through Glass Via, TGV), which is ordinarily formed in a product area. For example, a defect is deliberately formed in a substrate material, and etching is performed for the material. The formation of a defect may be performed by applying mechanical etching, laser irradiation, and the like. The etching may be applied by chemical etching, or may be applied by chemical etching and physical etching at the same time. For example, the chemical etching may be operated by adding ultrasonification and the like, after placing a glass substrate, in which a concave has been formed, to be in a bath comprising hydrofluoric acid and/or nitric acid. At this time, the concentration of hydrofluoric acid may be 0.5 M or more, or 1.1 M or more. The concentration of hydrofluoric acid may be 3 M or less, or 2 M or less. The concentration of nitric acid may be 0.5 M or more, or 1 M or more. The concentration of nitric acid may be 2 M or less. The ultrasonification may be operated with a frequency of 40 Hz to 120 Hz, or 60 Hz to 100 Hz.

The formation of a concave or a via in the protective area may proceed with an etching process for forming a via, a cavity space, or the like of the product area at the same time, and through the above, it is possible to improve yield of manufacturing a substrate for packaging dramatically, because the speed of manufacture is not lowered substantially while a protective area is formed, in addition to decreasing the ratio of defects.

The embedding of the heterogeneous material into a concave or a via of the protection region may be performed together with a process of forming an electrode and/or forming an insulating layer in the product region. The process of forming a redistribution layer including electrodes and insulating layers of the packaging substrate may be applied by methods such as copper plating and vacuum lamination of the ABF layer, and the detailed description thereof will be omitted.

### Use for Substrate 900 and Semiconductor Packaging Substrate

In one general aspect, a substrate 900 according to another embodiment is applied to a manufacture of a semiconductor packaging substrate, and comprises a core-substrate 100.

The core-substrate 100 is applied by the core-substrate described in the above.

The core-substrate 100 comprises one side and the other side facing each other.

An upper rewiring layer 300 is disposed on one side of the core-substrate, and the upper rewiring layer comprises an upper insulating layer and an upper electronically conductive layer disposed within the upper insulating layer.

In the upper rewiring layer of the embodiment, an insulating layer and an electronically conductive layer formed by a metal or the like are together, wherein the electronically conductive layer may be formed to be embedded inside the insulating layer in a predetermined position and shape. The electronically conductive layer may be formed to be a fine line in at least some of the upper rewiring layer.

A lower rewiring layer 500 and/or a bump 600 may be disposed under the other side of the core-substrate.

The lower rewiring layer 500 may comprise a lower insulating layer and a lower electronically conductive layer disposed within the lower insulating layer.

In the lower rewiring layer 500 of the embodiment, an insulating layer and an electronically conductive layer formed by a metal or the like are combined to be loaded, wherein an electronically conductive layer may be formed to be embedded inside the insulating layer in a predetermined position and shape.

Additionally, the lower rewiring layer and the upper rewiring layer may be electronically connected from each other by an electronically conductive layer and the like passing through a core-substrate according to a predetermined arrangement plan.

Additionally, a bump may be disposed in a predetermined shape in some of the product area. For example, the bump may be disposed in some of the upper side of the substrate, which is an area for mounting semiconductor elements. For example, the bump may be disposed in some of the lower side of the product area which has been disposed to be in contact with a mainboard and the like.

The coefficient of thermal expansion of the lower rewiring layer 500 or that of the bump 600 may be larger than the coefficient of thermal expansion of the core-substrate.

The upper rewiring layer or the lower rewiring layer disposed on the substrate 900 of the embodiment may be respectively, formed through processes of repetitively forming and removing an insulating layer and an electronically conductive layer, and in this process, an insulating layer and/or an electronically conductive layer may be formed in a concave or a via of the protective area, naturally (Refer to FIG. 10).

The upper rewiring layer or the lower rewiring layer disposed on the substrate 900 of the embodiment may be formed at a position excepting for a part or the whole of the protective area (Refer to FIG.9).

The concave or the via of the protective area may be filled with a filling material.

As the filling material, an insulating material, a heat radiating material, or both of them may be applied.

The filling may be made by an insulating material, or a heat radiating material.

The insulating material may be for example, a build-up layer material like ABF (Ajinomoto Build-up Film) available from Ajinomoto corporation, an undercoat material, and the like, but the material is not limited thereto.

The heat radiating material may be a material having a larger thermal conductivity than ceramic or glass, and for example, a metal heat radiating material and a polymer composite heat radiating material may be applied. Specifically, an aluminum-based heat radiating material, a copper-based heat radiating material, and the like may be applied as the heat radiating material, but the material is not limited thereto.

The concave or the via may not be filled.

The concave or the via may not be filled and connected to an external of the substrate. In such a case, the concave or the via may help heat radiation of the core-substrate during a manufacturing process of a substrate.

The concave or the via may be completely filled or partially filled.

When the concave or the via is filled, the occurrence of stress may be reduced in a substrate depending on the filling material.

The protective area 25 of the core-substrate 100 may protect the product area from damage going into the internal of the core-substrate from the edge of the core-substrate. The concave or the via may serve as a stopper when damage occurs in the core-substrate.

The substrate 900 of the embodiment is a substrate comprising a core-substrate utilized in semiconductor packaging, wherein the core-substrate 100 is distinguished into a product area 10 where a product utilized as a substrate 900 of an individual semiconductor; and a blank area 20 excepting for the product area; wherein the blank area 20 comprises a protective area 25 disposed to surround the product area, and the protective area 25 may substantially suppress the break, which is substantially perpendicular to the thickness direction from the edge of the core-substrate, not to go into the product area.

The use of the substrate according to the embodiment is a use of a substrate comprising a glass plate for manufacturing a substrate for semiconductor packaging. The core-substrate is distinguished into a product area where a product utilized as a packaging substrate of an individual semiconductor is disposed; and a blank area excepting for the product area, wherein the blank area comprises a protective area disposed to surround the product area, the substrate has a use of mounting semiconductor elements, and the semiconductor elements may be mounted on one side of the substrate or in a cavity space of the substrate.

### Packaged Semiconductor

A packaged semiconductor (not shown) according to another embodiment comprises a substrate for semiconductor packaging; and an element placed in the substrate. The description on the substrate is the same as described in the above and thus the further description is omitted.

The element may be applied by an operation element such as CPU and GPU, a memory element such as a memory chip, and the above elements may be applied together side by side or by being laminated together.

The element may be disposed on one side of the substrate, or may be disposed inside the substrate. A space inside the substrate which is so-called cavity is formed, and thereby it is possible to mount some or the whole of elements to be disposed inside the substrate, substantially.

The element may be a high frequency semiconductor element. When a high frequency semiconductor element is applied with a substrate for packaging together, a parasite element does not occur substantially in an environment with a high frequency, to be different from a silicon substrate and the like, and the efficiency can be increased. Additionally, in the above case, it is possible to embodying a rewiring line in a compact size, to be different from a prepreg substrate.

A core-substrate, a substrate, a use of the substrate, a semiconductor device, and the like of the present disclosure can substantially suppress the occurrence of damage in a product area utilized as a substrate for semiconductor packaging, even though a core-substrate which may be easily broken by external impact is applied thereto. The present disclosure may prevent the product area from being broken even if the glass plate itself is broken due to a stress applied to the substrate itself during various processes such as via formation, rewiring layer formation, and/or electrode formation on the substrate made of a glass plate material, and may substantially improve process efficiency.

Although the exemplary embodiments have been described in detail, the scope of the present invention is not limited thereto, and modifications and alterations made by those skilled in the art using the basic concept of the present invention defined in the following claims fall within the scope of the present invention.

It will be apparent to those skilled in the art that various modifications and variations can be made to the disclosed embodiments without departing from the scope or spirit of the disclosure. In view of the foregoing, it is intended that the disclosure covers modifications and variations provided that they fall within the scope of the following claims and their equivalents.

### DESCRIPTION OF FIGURE NUMBERS

| | | | |
|---|---|---|---|
| 900: | Substrate | 100: | Core-substrate |
| 10: | Product Area | 1: | product boundary line |
| 20: | Blank Area | 25: | Protective Area |
| 251: | Via | 252: | First Row |
| 253: | Second Row | 255: | Concave |
| 300: | Upper Rewiring Layer | 500: | Lower Rewiring Layer |
| 600: | Bump | P: | External Force |
| D: | Damage | | |

## Claims

1. A core-substrate for a manufacture of a semiconductor packaging substrate,
wherein the core-substrate is distinguished into a product area and a blank area,
where the product area is an area that a product utilized as a substrate of an individual semiconductor is disposed; and the blank area is an area excepting for the product area,
wherein a protective area is disposed at the blank area, and the protective area comprises a concave or a via.

2. The core-substrate of claim 1,
wherein the core-substrate is a substrate selected from the group consisting of a silicon-based ceramic substrate, a glass-based ceramic substrate, a glass substrate, and combinations thereof.

3. The core-substrate of claim 1,
wherein the product area is an area where one, two, or more individual packaging substrates are disposed.

4. The core-substrate of claim 1,
wherein the via or the concave is arranged in a row surrounding at least some of the edges of the product area.

5. The core-substrate of claim 1,
wherein the via or the concave has the shape of an oval or a quadrangle having a length of 20 % to 150 % of one side of the edge of the product area.

6. The core-substrate of claim 1,
wherein the inside of the via or the concave is disposed an electrically conductive material, an insulating material, or both of them.

7. The core-substrate according to any one of the preceding claims,
wherein the protective area comprises two or more rows respectively having different distances from the edges of the product area, and
wherein the two or more rows comprise a first row and a second row arranged side by side, and a via of the first row and a via of the second row are staggered with each other.

8. The core-substrate according to any one of the preceding claims,
wherein the protective area protects the product area from damage, which from the edge of the core-substrate goes into the internal of the core-substrate.

9. A substrate applied to a manufacture of a semiconductor packaging substrate, comprising: a core-substrate according to claim 1,
wherein the core-substrate comprises one side and the other side facing each other, and the core-substrate comprises an upper rewiring layer disposed on one side thereof; a lower rewiring layer disposed under the other side thereof; or both rewiring layers,
wherein the upper rewiring layer comprises an upper insulating layer and an upper electronically conductive layer disposed in the upper insulating layer, and the lower rewiring layer comprises a lower insulating layer and a lower electronically conductive layer disposed in the lower insulating layer.

10. The substrate of claim 9,
wherein the via or the concave is a removed part of the core-substrate, and
the removed part are filled with a filling material.

11. A substrate utilized in semiconductor packaging,
wherein the substrate comprises a core-substrate,
wherein the core-substrate is distinguished into a product area where a product utilized as a substrate of an individual semiconductor is disposed; and a blank area excepting for the product area,
wherein the blank area comprises a protective area disposed to surround the product area, and
the protective area substantially suppresses damage, which occurs in the direction substantially perpendicular to the thickness direction from the edge of the core-substrate, not to go into the product area.

12. A use of the substrate,
which is the use of a substrate comprising a glass plate or manufacturing a substrate for semiconductor packaging, and
the core-substrate is distinguished into a product area where a product utilized as a packaging substrate of an individual semiconductor is disposed; and a blank area excepting for the product area,
wherein the blank area comprises a protective area disposed to surround the product area,
the substrate has a use of mounting semiconductor elements, and
the semiconductor elements are mounted on one side of the substrate or in a cavity space of the substrate.
